# EUROPÄISCHE PATENTSCHRIFT

(11) **EP 1 096 423 B1**
(45) Veröffentlichungstag und Bekanntmachung des Hinweises auf die Patenterteilung: **08.09.2010**
(21) Anmeldenummer: 00120624.2
(22) Anmeldetag: 21.09.2000
(51) Int. Cl.: G06K 19/077, H05K 3/00

(54) **Verfahren und Vorrichtung zur Erzeugung einer fehlerfreien Materialbahn sowie fehlerfreien Materialbahn**
Method and apparatus for providing a defect free web and defect free web
Procédé et dispositif permettant d'obtenir une bande de matière sans défaut et bande de matière sans défaut

(30) Priorität: 29.10.1999 DE 19952471
(43) Veröffentlichungstag der Anmeldung: 02.05.2001
(73) Patentinhaber: bielomatik Leuze GmbH + Co. KG, 72639 Neuffen (DE)
(72) Erfinder: Bohn, Martin, 72762 Reutlingen (DE); Scheller, Wolfgang, 97241 Oberpleichfeld (DE); Högenett, Helmut, 52385 Nideggen (DE)
(74) Vertreter: Thul, Hermann

(56) Entgegenhaltungen:
- US-A- 4 703 858
- US-A- 5 952 841

## Beschreibung

Die Erfindung betrifft sowohl ein Verfahren als auch eine Vorrichtung zur Erzeugung einer Materialbahn mit auf ihr ablösbar aufgebrachten ausschließlich fehlerfreien Informationsträgern.

Aus der US-A-5952841 ist ein Verfahren zur Herstellung einer Materialbahn mit daran lösbar befestigten Halbleiterchips bekannt, bei dem die Halbleiterchips von einer Bahn entnommen, anschließend getestet und, falls der Halbleiterchip in Ordnung ist, wieder auf dieselbe oder eine andere Bahn aufgesetzt werden, um eine Bahn mit ausschließlich fehlerfreien Halbleiterchips zu erzeugen.

Aus der nicht vorveröffentlichten EP 0 996087 ist ein Verfahren und eine Vorrichtung zur Erzeugung einer Abfolge von fehlerteilfreien Bauteilen auf einer Materialbahn bekannt. Bei diesem Verfahren wird eine Materialbahn, die aus einer Trägerbahn besteht, auf der in regelmäßigen Abständen Informationsträger angeordnet sind, zugeführt. Die zugeführte Bahn enthält dabei nicht nur fehlerfreie Informationsträger, sondern auch Informationsträger, die Fehler aufweisen. Die Fehlerrate liegt dabei im Bereich des Produktionsausschusses der Herstellung der Informationsträger. Zur Weiterverarbeitung der Informationsträger ist es jedoch erforderlich, alle fehlerhaften Informationsträger auszuschneiden. Hierzu wird gemäß dem gattungsgemäßen Verfahren die zugeführte Materialbahn auf fehlerhafte Informationsträger überprüft. Wird ein Informationsträger als fehlerhaft erkannt, so wird in einer Schneidvorrichtung die Trägerbahn sowohl unmittelbar vor, als auch unmittelbar nach dem fehlerhaften Informationsträger durchgeschnitten. Anschließend werden die freien Enden der Trägerschicht miteinander verklebt und verpresst.

Die aus der genannten Druckschrift EP 0 966 087 der gattungsgemäß zugrundegelegten Vorrichtung zur Erzeugung einer Materialbahn, weist eine Zufuhr einer fehlerhafte Teile aufweisenden Materialbahn auf, eine Schneidvorrichtung zum Schneiden der Trägerbahn der Materialbahn, eine Klebe- und Preßvorrichtung zum automatischen Aneinandersetzen der freien Enden der Trägerbahn sowie eine Ausgabevorrichtung, bei der die ausgegebene Abfolge von fehlerfreien Informationsträgern zur Weiterverarbeitung gesammelt wird.

Bei diesem aus dem gattungsgemäßen Stand der Technik bekannten Verfahren und der zugehörigen Vorrichtung wird die Trägerbahn der Materialbahn durchtrennt und wieder angesetzt wird. Dadurch wird zunächst eine anhaltende Wiederverwertung der Trägerbahn unmöglich, da sie eine Vielzahl von Schneid- und Wiederbefestigungsstellen aufweist, auf die keine Informationsträger aufgebracht werden können. Darüber hinaus weist die Trägerbahn an den Klebe- oder Verschweißstellen unter Umständen Verdickungen auf, die sich bei der weiteren Verarbeitung der Informationsträger unter Umständen als störend erweisen könnte.

Aufgabe der Erfindung ist es, eine Materialbahn, bestehend aus einer Trägerbahn und darauf angeordneten Informationsträgern zu schaffen, bei denen die Trägerbahn als durchgehende Bahn ausgebildet ist und auf der lediglich fehlerfreie Informationsträger in einem gleichmäßigen Rastermaß angeordnet sind.

Die kennzeichnenden Merkmale der unabhängigen Patentansprüche führen bei Zugrundelegen der jeweiligen gattungsgemäßen Merkmale zur Lösung der Aufgabe.

Ein erfindungsgemäßes Verfahren zur Erzeugung einer Materialbahn mit auf ihr ablösbar aufgebrachten fehlerfreien Informationsträger ist in Anspruch 1 definiert.

Weitere Ausgestaltungen des erfindungsgemäßen Verfahrens können den darauf rückbezogenen Unteransprüchen entnommen werden.

Eine erfindungsgemäße Vorrichtung ist in Anspruch 6 definiert.

Weitere Ausgestaltungen der erfindungsgemäßen Vorrichtung können den darauf rückbezogenen Unteransprüchen entnommen werden.

Die gemäß der Erfindung erzeugte Materialbahn weist auf einer Trägerbahn lösbar angeordnete Informationsträger auf. Dabei ist die Trägerbahn als durchlaufende, kontinuierliche Bahn ausgebildet. Auf der Trägerbahn sind lediglich fehlerfreie Informationsträger gleichmäßig beabstandet angeordnet.

Nachfolgend wird die Erfindung anhand der in der Zeichnung dargestellten Ausführungsbeispiele näher erläutert. Dabei zeigt:
- Fig. 1:: Die Darstellung einer erfindungsgemäßen Vorrichtung zur Ausführung eines erfindungsgemäßen Verfahrens;
- Fig. 2:: Das Flußdiagramm des ersten erfindungsgemäßen Verfahrens zur Durchführung auf der erfindungsgemäßen Vorrichtung;
- Fig. 3:: Eine zweite, nicht erfindungsgemäße Vorrichtung zur Durchführung eines nicht erfindungsgemäßen Verfahrens;
- Fig. 4:: Das Flußdiagramm eines zweiten, nicht erfindungsgemäßen Verfahrens zur Durchführung auf der zweiten Vorrichtung.
- Fig. 5a, 5b:: Die Darstellung eines Umsetzers für Informationsträger.
- Fig. 6:: Die schematische Darstellung einer Materialbahn.
- Fig. 7:: Ausgestaltung einer erfindungsgemäßen Vorrichtung

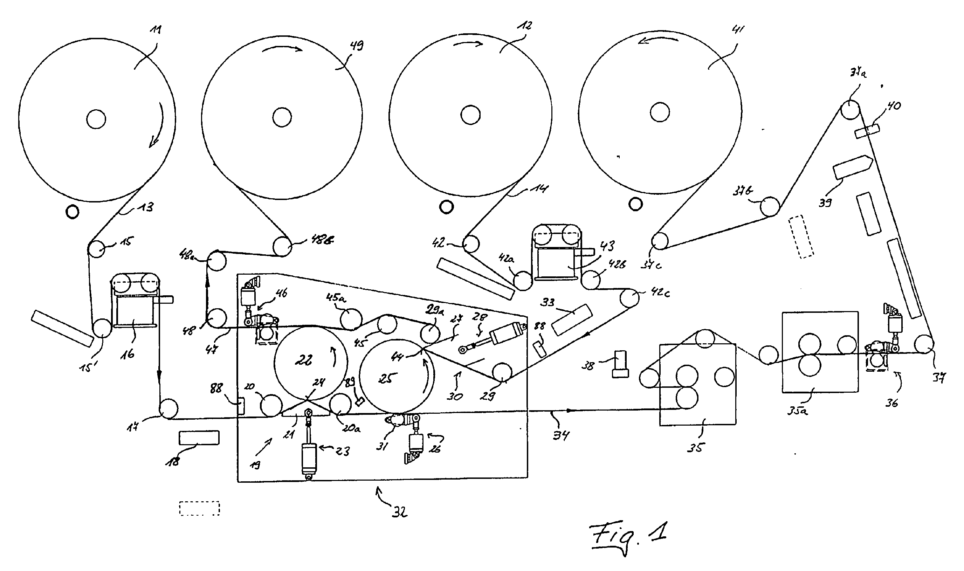

Die Figur 1 zeigt eine erfindungsgemäße Vorrichtung, die zwei Zuführeinrichtungen für fehlerhafte Informationsträger aufweisende Materialbahnen sowie je eine Ausgabeeinrichtung für eine ausschließlich fehlerfreie Informationsträger und für ausschließlich fehlerhafte Informationsträger aufweisende Materialbahnen aufweist. Die Materialbahn wird dabei jeweils gebildet aus einer Trägerbahn die, in regelmäßigen Abständen angeordnet, Informationsträger aufweist. Gemäß dem dargestellten Ausführungsbeispiel bestehen die Zuführeinrichtungen aus auf Wickeldornen angeordneten Rollen 11, 12 von denen je eine Materialbahn 13, 14 abgespult wird, die auch fehlerhafte Informationsträger aufweisen kann. Die erste Materialbahn 13, die von der Rolle 11 abgespult wird, wird über die Umlenkrollen 15, 15' zu dem Materialbahnausrichter 16 zugeführt. Ist die Umlenkrolle 15 verschwenkbar angeordnet, so kann sie auch als Pufferspeicher für die Materialbahn dienen, indem sie so verschwenkt wird, daß je nach Bedarf der Weg der Materialbahn um die Umlenkrolle 15 zur Umlenkrolle 15' länger oder kürzer wird. Die Pufferung kann dabei jeweils auch der Regulierung der Zugspannung in der Material- bzw. Trägerbahn dienen. Die Zugepannung kann beispielsweise über einen auf die verschwenkbare Umlenkrolle einwirkende Kraftspeicher oder dergleichen aufgebracht werden. Ist die Zugspannung steuer- oder regelbar, so kann die Zugspannung über entsprechende Meßwalzen, die gleichzeitig als Umlenkrollen dienen können, erfaßt werden.

Im Materialbahnausrichter 16 wird die erste Materialbahn 13 bezüglich ihrer Lage quer zu ihrer Vorschubrichtung präzise ausgerichtet. Über die weitere Umlenkrolle 17, wird die erste Materialbahn 13 an der Erkennungseinrichtung 18 vorbeigeführt. Die Erkennungseinrichtung 18 erfaßt die einzelnen, an ihr vorbeigeführten Informationsträger, liest deren Informationsgehalt und überprüft sie nach vorgegebenen Kriterien auf die Richtigkeit des Informationsgehaltes. Entspricht ein Informationsträger den festgelegten Kriterien, so gilt er als fehlerfrei. Entspricht er diesen Kriterien nicht, so gilt er als nicht fehlerfrei oder fehlerhaft.

Zur Ablösung fehlerhafter Informationsträger von der Materialbahn 13, dient die Ablösevorrichtung 19. Die Ablösevorrichtung 19 wird gebildet aus zwei Führungsrollen 20, 20 a, dem Schälkeil 21 und der Saugwalze 22. Der Schälkeil 21 kann mittels des Stellorgans 23 so in den Bahnverlauf eingebracht werden, daß der Schälkeil die geradlinige Transportrichtung der Materialbahn zwischen den beiden Führungsrollen 20, 20 a ablenkt und die Materialbahn daher im Bereich der Ablösekante 24 des Schälkeils 21 eine Umlenkung mit einem sehr geringen Umlenkradius erfährt. Die Saugwalze 22 befindet sich dann, wenn der Schälkeil den Bahnverlauf der Materialbahn 13 verändert, im Bereich der Ablösekante 24 in Anlage mit der Materialbahn 13. Das Zusammenwirken des Schälkeils 21 mit seiner Ablösekante 24 mit der Saugwalze 22 führt zu einem Ablösen, einem Abschälen, des sich dann im Bereich der Ablösekante 24 befindenden Informationsträgers. Der Schälkeil 21 wird in die dargestellte Eingriffslage gebracht, wenn in der Erkennungseinrichtung 18 ein nicht fehlerfreier Informationsträger erkannt wurde und dieser sich durch den Weitertransport der Materialbahn nun im Bereich des Schälkeils 21 befindet. Dabei ist darauf zu achten, daß der Schälkeil genau so in Abhängigkeit der Bahngeschwindigkeit der Materialbahn in die dargestellte Eingriffstellung gebracht wird, daß der Anfang des als nicht fehlerfrei erkannten Informationsträgers dann in dem Bereich der Ablösekante 24 gelangt, wenn diese sich schon in Anlage mit der Saugwalze 22 befindet. Hierzu kann es erforderlich sein, die Transportgeschwindigkeit der Materialbahn zu reduzieren oder einen taktweisen Vorschub der Materialbahn um einzelne Informationsträger vorzunehmen. Mittels des Stellorgans 23 wird dann der Schälkeil 21, wenn der als fehlerhaft erkannte Informationsträger abgeschält, bzw. abgelöst wurde, aus der direkten Verbindung zwischen den beiden Führungsrollen 20, 20 a herausgefahren. In der dann erreichten Ruhestellung befindet sich die Materialbahn 13 ggf. zwar noch in Anlage am Schälkeil 21, insbesondere an dessen Ablösekante 24, erfährt aber keine Umlenkung mit einem engen Radius mehr durch den Schälkeil 21. Daher kommt es auch nicht mehr zu einem Abschälen oder Ablösen des dann am Schälkeil 21 vorbeigeführten Informationsträgers. In dieser Ruhestellung werden die als fehlerfrei erkannten Informationsträger am Schälkeil 21 vorbeigeführt. Zur Einsteuerung der Bahnen können jeweils Sensoren 88 vorgesehen sein, die eine Lageerkennung der Bahn bzw. eines Informationsträgers bezüglich dem Schälkeil 21 bzw. 28 erfassen kann.

Im Anschluß daran wird die Materialbahn, die nur noch fehlerfreie Informationsträger oder Lücken aufweist, weiter transportiert. Für den Antrieb der Materialbahn sorgt die Antriebseinrichtung 36. Das Zusammenwirken der zweiten saugwalze 25 mit der Andrückwalze 31 sorgt für den geeigneten Anpreßdruck für die Übernahme eines fehlerfreien Informationsträgers. Erfolgt eine Übernahme eines Informationsträgers, so kann die Andurckwalze 31 von der Saugwalze 25 weggefahren werden. Der Weg vom Ablösepunkt von der ersten Materialbahn 13 bis zum Anlagepunkt des zweiten Transportelements 25 an der Materialbahn 13 sollte größer sein als die längste verarbeitbare Ausdehnung eines Informationsträgers. Über die Saugwalze 25 können der Materialbahn 13 als fehlerfrei erkannte Informationsträger zugeführt werden und über eine geeignete Steuerung der Drehgeschwindigkeit der zweiten Saugwalze 25 und des Vorschubes der Materialbahn 13 wird eine lagegenaue Zufuhr der fehlerfreien Informationsträger gewährleistet, so daß die als fehlerfrei erkannten Informationsträger passgenau in die Lücke eingesetzt werden, die entsteht, wenn in der Ablösevorrichtung 19 ein fehlerhafter Informationsträger von der Materialbahn 13 abgelöst wurde. Hierzu kann an vorgegebener Position bezüglich dem Anlagepunkt des zweiten Transportelements an der ersten Materialbahn ein Sensor 89 vorgesehen sein, der die Bereitstellung eines fehlerfreien Informationsträgers auf dem Transportelement 25 überwacht. Die beiden Transportelemente 22, 25 weisen vorzugsweise für den Transport eines Informationsträgers jeweils eine Transportlänge auf, die größer ist, als der längste zu verarbeitende Informationsträger.

Durch das Zusammenwirken der Ablöseeinrichtung 19 und dem passgenauen Einsetzen eines fehlerfreien Informationsträgers wurde somit aus der auch fehlerhafte Informationsträger aufweisenden ersten Materialbahn 13 die ausschließlich fehlerfreie Informationsträger aufweisende fehlerfreie Materialbahn 34. Diese wird an der Kontrolleinrichtung 38, zum Beispiel einer Kamera, vorbeigeführt, um zu kontrollieren, daß das Einsetzen der fehlerfreien Informationsträger auch ordnungsgemäß stattgefunden hat. In den nachfolgend anordenbaren Bearbeitungsstationen 35, 35 a kann die Materialbahn mit den Informationsträgern weiter bearbeitet werden. In der weiteren Bearbeitung kann beispielsweisean gewünschten Stellen das Einbringen von Soll-Trennstellen am Informationsträger selbst oder an der Trägerbahn stattfinden. Über die weitere Antriebseinrichtung (36) wird der Transport der Materialbahn mit dem gewünschten Vorschub sichergestellt. Über die Umlenkrolle 37 gelangt die Materialbahn 34, die die gleiche Trägerbahn beinhaltet wie die ursprüngliche Materialbahn 13, zu der Beschriftungseinrichtung 39. Hier können die Informationsträger in laufender Abfolge beschriftet werden. Sie können beispielsweise fortlaufend nummeriert werden, wobei sichergestellt ist, daß jeder der fortlaufenden nummerierten Informationsträger auch zur Verwendung tauglich ist und dabei kein Ausschuß mitgezählt wird. Die Materialbahn 34 wird dann durch das Zählwerk 40 hindurchgeführt. Hier können die Informationsträger nochmals gezählt werden, so daß es möglich ist, die Materialbahn 34 in Segmente zu unterteilen, die jeweils die gleiche Anzahl verwertbarer Informationsträger aufweist. Über weitere Umlenkrollen 37a, 37b und 37c wird die Materialbahn 34 zur Ausgabeeinrichtung für die fehlerfreien Informationsträger geführt. Es handelt sich dabei um eine Wickelstation 41. Anstelle des Aufwickelns der Materialbahn 34 kann auch ein Stapeln der Materialbahn erfolgen, wobei die Stapelung beispielsweise durch Stapeln einer zickzackförmig gefalteten Materialbahn erfolgen kann, wobei die Faltung jeweils zwischen aufeinanderfolgenden Informationsträgern erfolgt, so daß kein Informationsträger geknickt wird. Erfolgt ein Aufwickeln der fehlerfreien Materialbahn 34 in einer Wickelstation 41, so kann die Umlenkrolle 37c als Pufferspeicher dienen, indem sie so angeordnet ist, daß ihre Lage bezüglich der Wickelstation 41 verändert werden kann und daher die Bahnlänge zwischen Wickelstation 41 und Umlenkrolle 37b verändert werden kann.

Damit der Materialbahn 13 fehlerfreie Informationsträger zugeführt werden können, ist eine zweite Materialbahn 14 vorgesehen, die von der Materialbahnrolle 12 abgewickelt werden kann. Die Materialbahn 14 kann dabei auch fehlerhafte Informationsträger beinhalten. Sie wird über die Umlenkrollen 42 und 42 a der Bahnausrichtungseinrichtung 43 zugeführt. Dort wird die Lage der zweiten Materialbahn 14 in Querrichtung ihrer Förderrichtung justiert. Anschließend wird die Materialbahn 14 über die Umlenkrollen 42b und 42c geführt. Danach wird sie an der zweiten Erkennungseinrichtung 33 vorbeigeführt. Die Erkennungseinrichtung 33 entspricht der Erkennungseinrichtung 18 und dient der Unterscheidung zwischen fehlerfreien und fehlerhaften Informationsträgern aufgrund vorgegebener Kriterien. Die Materialbahn 14 wird dann zu der zweiten Ablösevorrichtung 30 geführt. Die zweite Ablösevorrichtung 30 wird gebildet aus den Führungsrollen 29, 29a, dem Schälkeil 27 und der Saugwalze 25. Der Schälkeil 27 ist an dem Stellorgan 28 angeordnet und kann in die gerade Verbindungslinie zwischen den beiden Führungsrollen 29 und 29 a in eine Wirkstellung hineingefahren werden, wie dies in der Zeichnung dargestellt ist. In dieser Wirkstellung werden Informationsträger an der Ablösekante 44 des Schälkeils 27 dadurch abgelöst, daß sich die Ablösekante in Anlage an der Saugwalze 25 befindet und einen engen Radius aufweist. Entsprechend der Ablösevorrichtung 19 kann der Schälkeil 27 auch in eine Stellung gebracht werden, in der er die Materialbahn nicht so ablenkt, daß ein Abschälen bzw. ein Ablösen der Informationsträger von der Trägerbahn der Materialbahn 14 erfolgt. Im Gegensatz zur Ablösung der fehlerhaften Informationsträger von der Materialbahn 13 erfolgt über den Schälkeil 27 ein Ablösen fehlerfreier Informationsträger von der Materialbahn 14. Die Materialbahn 14 wird nach der Führungsrolle 29 a über weitere Umlenkrollen 45, 45 a in Anlage an die Saugwalze 22 gebracht. Der Bahnvorschub der zweiten Materialbahn 14 sowie die Rotationsgeschwindigkeit der beiden Saugwalzen 22 und 25 wird so gesteuert, daß im Anlagebereich der zweiten Materialbahn 14 an der Saugwalze 22 auf diese zweite Materialbahn 14 in eine von einem abgeschälten, fehlerfreien Informationsträger entstandenen Lücke der von der ersten Materialbahn 13 abgeschälte, fehlerhafte, Informationsträger, der von der Saugwalze 22 übernommen wurde, eingesetzt wird. Hierbei kann es erforderlich sein, daß die zweite Materialbahn 14 sowohl vorwärts als auch rückwärts bewegt werden kann. Hierzu dient die Transporteinrichtung 46. Durch den Vor- und Rücktransport der zweiten Materialbahn 14 kann sichergestellt werden, daß von ihr sämtliche fehlerfreien Informationsträger abgelöst werden. Ist dies der Fall, so wird die Materialbahn 14 im Anschluß an das Aufsetzen der fehlerhaften Informationsträger von der Saugwalze 22 zur Makulaturbahn 47, die geführt über die Umlenkrollen 48, 48 a, 48 b auf der Wickeltrommel 49 aufgewickelt wird. Entsprechend dem Zusammenwirken der Umlenkrollen 37 b und 37 c kann auch durch das Zusammenwirken der Umlenkrollen 48 a und 48 b eine Pufferung der Materialbahnlänge der Makulaturbahn 47 erfolgen.

Anstelle des lagegenauen Übernehmens des fehlerhaften Informationsträgers von dem Transportelement 22 durch die zweite Materialbahn 14 kann auch eine beliebige Übernahme erfolgen, wobei dann mehrere Informationsträger übereinander auf der Makulaturbahn 47 angeordnet sein können. Ein Rückfordern der Materialbahn 14 kann dann entfallen. Weiter alternativ kann anstelle der Übernahme der fehlerhaften Informationsträger auf einer Makulaturbahn 47 auch ein beliebiger anderer Abtransport, z.B. ein Absaugen, dieser erfolgen.

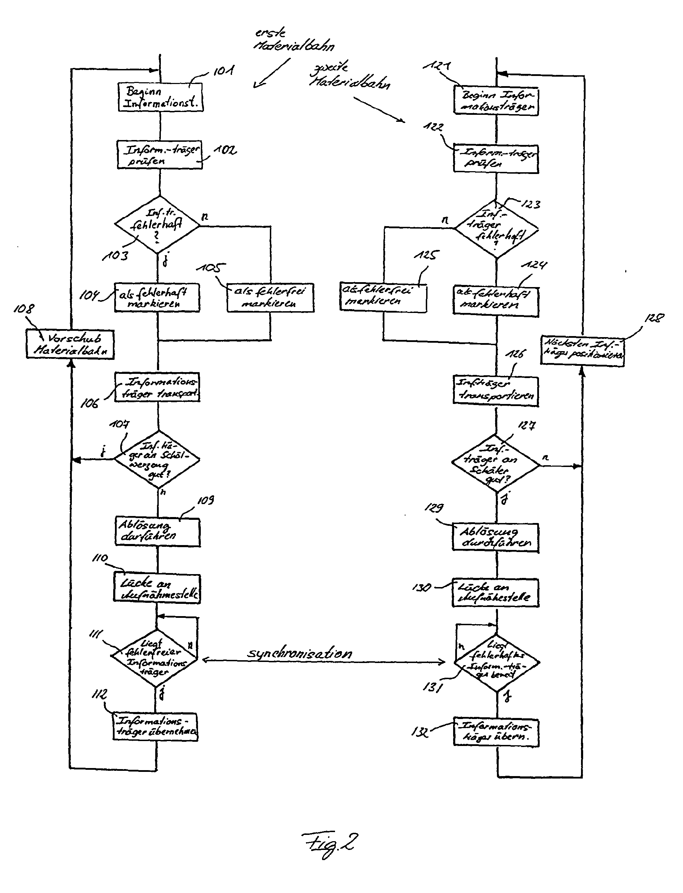

Die Figur 2 zeigt in schematischer Ausführung das Flußdiagramm eines erfindungsgemäßen Verfahrens, das zur Durchführung auf der Vorrichtung der Figur 1 geeignet ist.

Das Verfahren gliedert sich in zwei parallel zueinander stattfindenden Abläufe, die zueinander synchronisiert sind. Das Verfahren gemäß dieser Figur kann sowohl bei taktweisem Vorschub der Materialbahnen als auch bei kontinuierlichem Vorschub der Materialbahnen durchgeführt werden. Es ist lediglich wichtig, daß der Erkennungseinrichtung ausreichend Zeit bleibt, um fehlerhafte Informationsträger erkennen zu können und daß es zugleich möglich ist, den Vorschub und den Transport der abgelösten Informationsträger zueinander zu synchronisieren.

Die Verfahrensschritte 101 bis 112 beziehen sich im wesentlichen auf die Vorgehensweise betreffend die erste Materialbahn und die Verfahrensschritte 121 bis 132 beziehen sich im wesentlichen auf die zweite Materialbahn. Gemäß den Schritten 101 bzw. 121 wird im Bereich der jeweiligen Erkennungseinrichtung überprüft, ob der Beginn eines Informationsträgers vorliegt, es findet also eine Lageausrichtung statt. Gemäß dem Schritt 102 bzw. dem Schritt 122 wird eine Überprüfungsroutine für den jeweils an der Erkennungseinrichtung positionierten Informationsträger durchgeführt. Gemäß dem Schritt 103 bzw. dem Schritt 123 wird überprüft, ob der Informationsträger fehlerhaft ist, d.h. ob er bestimmte vorgegebene Kriterien nicht erfüllt, oder ob er fehlerfrei ist, also die vorgegebenen Kriterien hinreichend erfüllt. Entsprechend des Vorliegens eines fehlerfreien oder eines fehlerhaften Informationsträgers wird der jeweilige Informationsträger der entsprechenden Materialbahn gemäß den Schritten 104 oder 105 bzw. den Schritten 124 oder 125 als fehlerhaft oder als fehlerfrei markiert. Die Markierung eines Informationsträgers kann dabei in der Zuordnung einer logischen Information in einer Speichereinrichtung unabhängig vom Informationsträger selber vorgenommen werden und/oder zugleich auch in physikalischer Form auf dem Informationsträger selbst z.B. durch Anbringen eines entsprechenden Merkmals. Wird die Markierung als logische Information zugeordnet, so sollte bekannt sein, wieviel Informationsträger zwischen der Erkennungseinrichtung und der Abschäleinrichtung bzw. der Ablöseeinrichtung für den Informationsträger vom jeweiligen Materialband bekannt sein, damit die Zuordnung bis zu diesem Zeitpunkt nicht verloren geht.

Im Schritt 106 bzw. im Schritt 126 wird nunmehr der Informationsträger mit seiner Informationszuordnung über die Fehlerhaftigkeit weiter transportiert bis er das Schälwerkzeug bzw. das Ablösewerkzeug erreicht. Gemäß dem Schritt 107 wird bei der ersten Materialbahn überprüft, ob dem Informationsträger, der am Schälwerkzeug angelangt ist, die Information zugeordnet, daß er fehlerhaft ist oder nicht. Ist der Informationsträger nicht fehlerhaft, so wird zum Schritt 108 gesprungen und die Materialbahn um die Länge eines Informationsträgers weiter transportiert. Es wird dann zum Schritt 101 zurückgesprungen. Es ist dabei zu beachten, daß die Schritte 101 bis 106 gleichzeitig stattfinden wie die Schritte 107 bis 112, wobei dies zugleich jeweils für zwei unterschiedliche Informationsträger an unterschiedlicher Stelle der Materialbahn geschieht. Gleiches gilt für die entsprechenden Schritte des Verfahrens bezüglich der zweiten Materialbahn.

Wurde im Schritt 107 festgestellt, daß der vorliegende Informationsträger fehlerhaft ist, so kann er nicht auf der ersten Materialbahn verbleiben, es wird daher zum Schritt 109 übergegangen, gemäß dem der entsprechende Schälkeil 21 - als Führungselement für die Materialbahn in Vorschubrichtung - in Kontakt mit der ersten Materialbahn gebracht wird, wobei während des weiteren Vorschubes der Materialbahn die komplette Ablösung des fehlerhaften Informationsträgers erfolgt. Gemäß dem Schritt 110 wird dann die entstehende Lücke weiter gefördert, bis sie mit ihrem vorderen Ende ihren Aufsetzpunkt auf der zweiten Saugwalze 25 erreicht. Gemäß dem Schritt 111 wird dann überprüft, ob ein fehlerfreier Informationsträger auf der zweiten Saugwalze bereit liegt. Ist dies nicht der Fall, so wird eine Warteschleife durchgeführt. Gleichzeitig wird aber der Ablaufsteuerpunkt für das zweite Materialband mitgeteilt, daß an der ersten Saugwalze 22 ein fehlerhafter Informationsträger zur Übernahme bereitliegt. Gemäß dem Schritt 112, der dann durchgeführt wurde, wenn im Schritt 111 festgestellt wurde, daß ein fehlerfreier Informationsträger an der Saugwalze 25 bereit liegt, beginnt die passgenaue Übernahme dieses Informationsträgers von der Saugwalze 25 auf die erste Materialbahn 13, die dadurch zur fehlerfreien Materialbahn 34 wird, indem das vordere Ende des Informationsträgers passgenau mit dem vorderen Ende der Lücke des abgeschälten Informationsträgers eingefügt wird. Dazu wird die Saugwalze 25 synchron mit der Fortbewegung der Materialbahn 13 weiter bewegt. Im Anschluß an den Schritt 112 wird zum Schritt 108 zurückgesprungen, wonach die Materialbahn weiter vorgeschoben werden kann. Gleichzeitig zum Ablauf der Schritte 107 bis 112 erfolgt auch die Durchführung der Schritte 127 bis 132 für die zweite Materialbahn.

Im Schritt 127 wird überprüft, ob der an der Ablösevorrichtung 30 vorliegende Informationsträger als fehlerhaft markiert wurde, wenn dies der Fall ist, so wird zum Schritt 128 gesprungen und der nächste Informationsträger so weit vorgeschoben, bis zum Schritt 121 übergegangen werden kann. Andernfalls, also wenn im Schritt 127 erkannt wurde, daß der sich im Bereich der Ablösevorrichtung 30 befindliche Informationsträger gut ist, so wird gemäß dem Schritt 129 die Ablösung des Informationsträgers im Zusammenwirken der Ablösevorrichtung 30 mit der Saugwalze 25 durchgeführt. Im Anschluß daran wird gemäß dem Schritt 130 die durch diesen Ablösevorgang entstandene Lücke soweit weiter transportiert, bis der Auflagepunkt der ersten Saugwalze an der zweiten Materialbahn 14 erreicht wird. Gemäß dem Schritt 131 wird überprüft, ob an der Saugwalze 22 ein fehlerhafter Informationsträger zur Übernahme durch die zweite Materialbahn, die damit zur Makulaturbahn 47 wird, bereit liegt. Ist dies nicht der Fall, so wird eine Warteschleife durchgeführt. Gleichzeitig wird der Steuereinheit für die erste Materialbahn mitgeteilt, daß an der Saugwalze 25 nunmehr ein fehlerfreier Informationsträger bereit liegt.

Sobald ein fehlerhafter Informationsträger an der ersten Saugwalze 22 zur Übernahme durch die zweite Materialbahn bereit liegt, wird dieser Informationsträger gemäß dem Schritt 132 von der zweiten Materialbahn übernommen, indem die zweite Materialbahn synchron zur Rotation der ersten Saugwalze fortbewegt wird. Dabei kann ein Anpressen des Informationsträgers an die zweite Materialbahn durch ein Fördern durch die Vorschubeinrichtung 46 hindurch erfolgen. Anschließend wird gemäß dem Schritt 128 der nächste fehlerfreie Informationsträger, der sich nach der Stelle befindet, an dem der vorhergehende Informationsträger herausgelöst wurde und substituiert wurde, im Bereich der Ablösevorrichtung positioniert. Somit können alle aufeinanderfolgenden fehlerfreien Informationsträger von der zweiten Materialbahn 14 abgelöst werden, damit diese danach lediglich fehlerhafte Informationträger in ununterbrochener Reihenfolge aufweist. Alternativ dazu wäre es auch möglich, keinen Rücktransport der zweiten Materialbahn vorzunehmen und diese einfach so oft als zweite Materialbahn zu verwenden, bis wenigstens nahezu alle fehlerfreien Informationsträger abgelöst und auf eine fehlerfreie Informationsbahn 34 übertragen wurden. Die Wahl dieser beiden Methoden ist von der stochastischen Häufigkeit fehlerhafter Informationsträger abhängig.

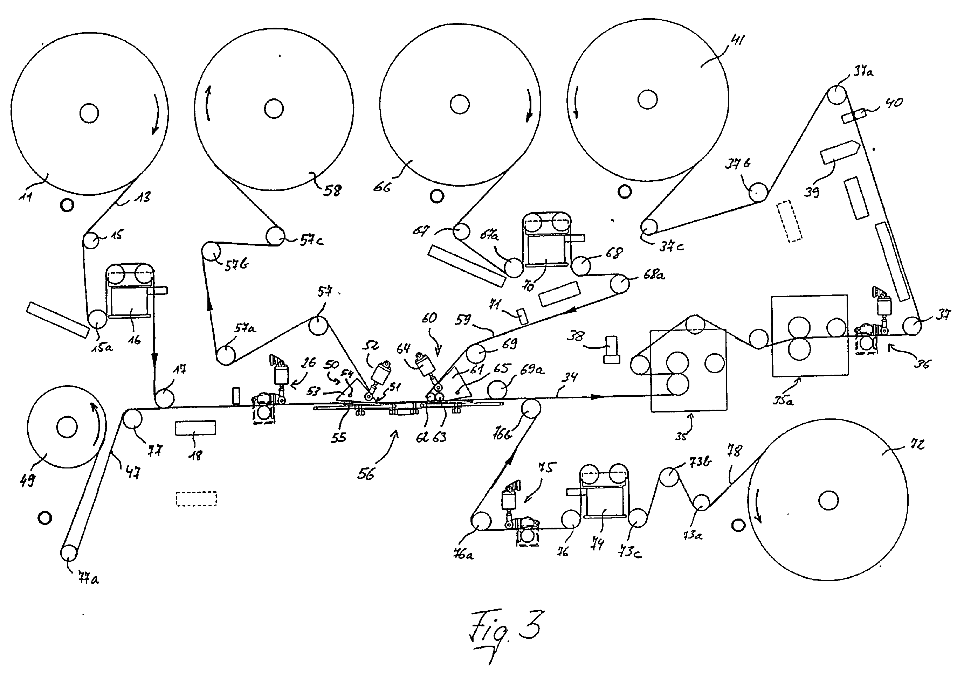

Die Figur 3 zeigt ein zweites, nicht erfindungsgemäßes Beispiel für eine Vorrichtung, die zur Durchführung eines nicht erfindungsgemäßen Verfahrens geeignet ist. Bei dieser Vorrichtung ist eine Zuführeinrichtung 11 für die Zufuhr einer ersten Materialbahn 13, die auch fehlerhafte Informationsträger beinhalten kann, vorgesehen. Über die Umlenkrollen 15 und 15 a wird die erste Materialbahn 13 zum Bahnausrichter 16 geführt, durch den die Bahnkantenlage justiert werden kann. Über die Umlenkrolle 17 wird die Materialbahn 13 dann an der Erkennungseinrichtung 18 vorbeigeführt. Die Erkennungseinrichtung 18 dient dazu, an ihr vorbeigeführte Informationsträger anhand vorgegebener Kriterien auf Fehlerfreiheit zu prüfen. Die erste Materialbahn 13 gelangt dann zur Antriebseinrichtung 26, über die die Materialbahn 13 entweder in kontinuierlichem Vorschub oder aber in schrittweise getakteten Vorschub transportiert wird. Im weiteren Verlauf der Materialbahn gelangt diese zur Ablöseeinrichtung 50. Die Ablöseeinrichtung 50 wird gebildet aus einem Ablösekeil 53, der an einer Schwenkachse 54 angelenkt ist und der um die Schwenkachse 54 durch das Stellorgan 52 betätigt schwenkbar ist. Der Ablösekeil 53 weist die Ablösekante 51 auf, über die die Materialbahn 13 geführt wird. In der dargestellten Wirkstellung des Ablösekeils 53 befindet sich die Ablösekante 51 in Anlage an einem Saugteller 55 des Umsetzers 56. Wird ein Informationsträger der Materialbahn 13 an der Ablösekante vorbeigeführt, so beginnt er sich von der Tragbahn der Materialbahn 13 abzulösen. Er wird von dem Saugteller 55 angesaugt und auf ihn übernommen.

Er ist also von der Tragbahn der Materialbahn 13 abgelöst. Nach dem Ablösen eines Informationsträgers wird der Ablösekeil 53 in eine Ruhelage zurückgeführt, in der sich die Ablösekante 51 nicht mehr in der Anlage an einem Saugteller 55 befindet, so daß der Saugteller 55 ungehindert weitertransportiert werden kann und ein neuer Saugteller 55 in die Position gegenüber der Ablösekante 51 des Ablösekeils 53 gebracht werden kann. Dabei kann die erste Materialbahn 13 entweder kontinuierlich durchlaufen oder aber in getaktetem Rhythmus jeweils immer um die Länge eines Informtionsträgers weitergefördert werden. Nach dem Vorbeiführen an dem Ablösekeil 53, durch den alle Informationsträger von der ersten Materialbahn 13 abgelöst werden, wird die nunmehr leere Tragbahn der ersten Materialbahn 13 über die Umlenkrollen 57, 57a, 57b und 57c geführt und dann auf der Trommel 58 aufgewickelt. Die auf der Trommel 58 aufgewickelte Tragbahn der Materialbahn 13 kann entweder wiederverwertet werden, indem sie erneut mit Informationsträgern besetzt wird, oder es kann eine andere Form des Recyclings der Tragbahn erfolgen. In ihrem Zusammenwirken können die Umlenkrollen 57b, die feststehend angeordnet sein kann und die Umlenkrolle 57c, die relativ beweglich zur Rolle 57b angeordnet sein kann, eine Puffereinrichtung bilden, so daß ein kontinuierliches ununterbrochenes Aufwickeln der Tragbahn der Materialbahn 13 auch dann erfolgen kann, wenn vorher ein taktweiser Transport der ersten Materialbahn zur Allöseeinrichtung erfolgt ist. Die Pufferung erfolgt einfach durch Veränderung der Weglänge zwischen der Umlenkrolle 57 b und der Trommel 58.

Die von der Materialbahn abgelösten Informationsträger werden somit auf den Saugtellern 55 vereinzelt. Auf dem Saugträger 55 kann entweder zusätzlich oder alternativ zur Erkennungseinrichtung 18 eine Überprüfung des Informationsträgers erfolgen. Durch Drehen des Saugtellers, beispielsweise um 90°, kann ein neues Ausrichten des Informationsträgers bezüglich der Transportrichtung der aufnehmenden Trägerbahn 59 erfolgen. Es kann sich aus fertigungstechnischen Gründen als vorteilhaft erweisen, daß bei der Herstellung der Informationsträger dieser sich mit seiner Längsachse in Laufrichtung der Trägerbahn der Materialbahn 13 befindet und dieser sich dann auf der Trägerbahn 59 mit seiner Querachse in Laufrichtung der Trägerbahn 59 befindet. Die nachfolgende Weiterverarbeitung kann dann beispielsweise in Transportrichtung der Materialbahn 34 und nicht quer dazu erfolgen. Als anhand der festgelegten Kriterien fehlerfrei erkannte Informationsträger werden auf eine Tragbahn 59 übernommen.

Die Tragbahn 59 wird der Übernahmeeinrichtung 60 zugeführt, indem sie von der Trommel 66 abgewickelt wird und über die Umlenkrollen 67 und 67a geführt wird. Die Tragbahn 59 wird anschließend im Bahnausrichter 70 bezüglich ihrer Lage quer zur Transportrichtung ausgerichtet und gelangt dann über die Umlenkrollen 68 und 68a zu der Führungsolle 69. Vor der Führungsrolle 69 kann noch ein Sensor 71 angeordnet sein, der die Tragbahn auf Beschädigung überprüft und/oder ein Lagebezug zwischen einer Rasterung der Trägerbahn 59 und der Übernahmestelle eines Informationsträgers auf der Trägerbahn herstellt. Nach der Führungsrolle 69 wird die Tragbahn 59 in der Übernahmeeinrichtung 60 über den Führungskeil 61 geführt. Dieser Führungskeil weist an seiner Spitze die beiden Andrukkrollen 62 und 63 auf, mittels der die darüber geführte Tragbahn an den auf dem Saugteller 55 befindlichen Informationsträger angedrückt wird, wodurch der Informationsträger auf dem Tragband 59 haftend befestigt ist. Das nun lediglich fehlerfreie Informationsträger aufweisende Tragband 59 wurde so zur Materialbahn 34. Damit in der Übernahmeeinrichtung 60 lediglich fehlerfreie Informationsträger übernommen werden, ist der Führungskeil 61 an der Schwenkachse 65 schwenkbar gelagert und kann durch das Stellorgan 64 in die dargestellte Funktionsstellung gebracht werden, in der die Andruckrollen 62 und 63 die Tragbahn in Anlage an den Informationsträger auf den Saugteller 55 bringen und in eine zweite Ruhestellung gebracht werden, in der die Andruckrollen 62 und 63 soweit vom Saugteller 55 entfernt sind, daß eine Übernahme eines Informationsträgers nicht stattfindet. In der letztgenannten Lage befindet sich der Führungskeil 61 dann, wenn entweder ein Saugteller mit einem fehlerhaften Informationsträger an ihm vorbeigeführt werden soll, bzw. wenn ein leerer Saugteller 55 abgeführt oder ein einen Informationsträger aufweisender Saugteller 55 zugeführt werden soll.

Nach Übernahme des Informationsträgers wird das Tragband 59, das nunmehr als nur fehlerfrei Informationsträger gleichmäßig beabstandet aufweisende Materialbahn 34 zu bezeichnen ist, über die Führungsrolle 69a abgeführt. Über eine Kontrolleinrichtung 38, beispielsweise eine Kamera, kann überprüft werden, ob das Aufnehmen der Informationsträger durch die Tragbahn fehlerfrei erfolgte. Die fehlerfrei Materialbahn 34 kann nun entsprechend dem in der Figur 1 beschriebenen Vorgehensweise den Bearbeitungsstationen 35 und 35 a zur weiteren Bearbeitung der Materialbahn zugeführt werden. Eine Antriebseinrichtung 36 sorgt dann für den Weitertransport der Materialbahn über die Umlenkrollen 37, vorbei an der Beschriftungsstation 39 und dem Zählwerk 40 über die Umlenkrollen 37 a, 37 b und 37 c zur Wickelstation 41 geführt werden, in der die zählerfreie Materialbahn 34 aufgewickelt wird.

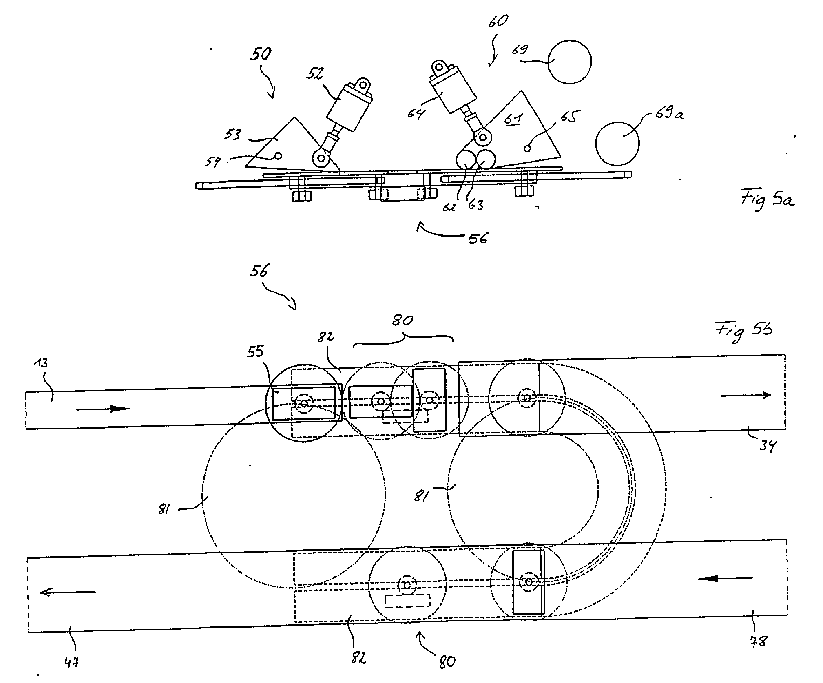

Der Umsetzer 56 mit seinen Saugtellern 55 ist nachfolgend in der Figur 5 näher beschrieben.

Zur Aufnahme fehlerhafter Informationsträger wird von einer Bereitstellungsrolle 72 eine Tragbahn 78 abgewickelt. Sie wird geführt über die Führungsrollen 73a und 73b, die in vorbeschriebener Weise der Relativiagenveränderung einen Puffer bilden können und über die Umlenkrolle 73c einem Bahnausrichter 74 zugeführt. Von dort gelangt die Tragbahn über die Umlenkrollen 76, die Antriebseinrichtung 75 sowie die weiteren Umlenkrollen 76a und 76b in den Bereich des Umsetzers 56, wobei in diesem Bereich die Tragbahn 78 parallel zu der ersten Materialbahn 13 und der fehlerfreien Materialbahn 34 verläuft, auf gleicher Höhe ausgerichtet ist, jedoch neben den beiden vorgenannten Bahnen - in der dargestellten Weise vor den beiden anderen Bahnen - verläuft. Die leere Tragbahn 78 verläuft so im Bereich des Umsetzers 56, daß sie die Informationsträger, die nicht auf die fehlerfreie Materialbahn 34 übertragen wurden, da sie als fehlerhaft erkannt wurden, übernimmt und somit zur Makulaturbahn 47 wird. Über weitere Umlenkrollen 77 und 77 a, die ebenfalls in bekannter Weise einen Puffer bilden können, gelangt die Makulaturbahn 47 zur Wickeltrommel 49, wo sie aufgewickelt wird.

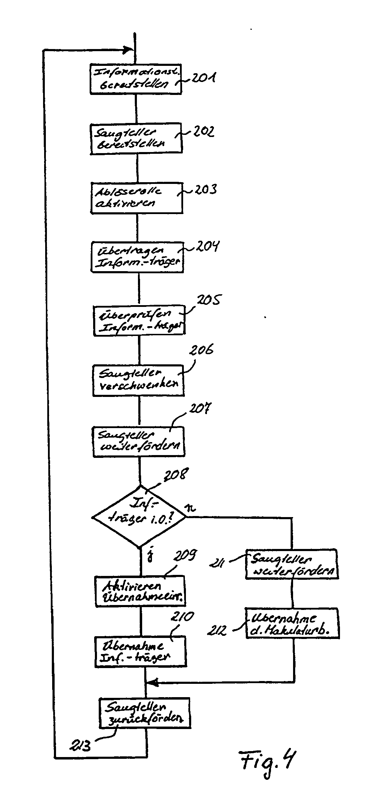

Die Figur 4 zeigt in schematischer Darstellung das Flußdiagramm eines Verfahrens zur Durchführung einer Vorrichtung gemäß Figur 3, dabei wird in diesem Verfahren unterstellt, daß die Überprüfung der Informationsträger auf Fehlerfreiheit während des Transportes auf dem Saugteller 55 erfolgt. Sollte die Überprüfung auf Fehlerfreiheit des Informationsträgers nicht auf dem Saugteller 55 sondern in einer vorgelagerten Erkennungseinrichtung 18 durchgeführt werden, so müßte ensprechend zum Verfahren gemäß Figur 2 eine Markierung der Informationsträger wenigstens in logischer Form durchgeführt werden und diese Information zusammen mit dem Informationsträger weiter transportiert werden.

Gemäß dem Schritt 201 wird ein Informationsträger an der Ablösevorrichtung 19 bereitgestellt; gemäß dem Schritt 202 wird im Bereich der Ablösevorrichtung 19 ein leerer Saugteller bereitgestellt. Gemäß dem Schritt 203 wird sodann der Schälkeil 21 in Anlage an den Saugteller 55 gebracht und der Informationsträger von der ersten Materialbahn abgeschält und auf den Saugteller 55 übertragen, wobei zum besseren Übertragen auf den Saugteller eine Ansaugung des Informationsträgers durch den Saugteller durchgeführt werden kann. Nach dem Übertragen des Informationsträgers auf den Saugteller gemäß dem Schritt 204 wird der Informationsträger gemäß dem Schritt 205 dahingehend überprüft, ob er fehlerfrei ist. Während der Druchführung dieser Überprüfung wird der Saugteller 207 weiter gefördert. Er kann dabei um 90° verschwenkt werden, so daß der Informationsträger bezüglich der Förderrichtung der fehlerfreien Materialbahn neu ausgerichtet wird.

Bevor der Saugteller in Übernahmestellung bei der Übernahmeeinrichtung 60 angelangt ist, steht fest, ob der Informationsträger in Ordnung, also fehlerfrei ist. Ist der Informationsträger nicht fehlerfrei, so wird gemäß dem Schritt 208 zum Schritt 211 gesprungen, der Saugteller wird dann an der Übernahmeeinrichtung vorbeigefördert, ohne daß eine Übernahme des Informationsträgers auf die fehlerfreie Materialbahn 34 erfolgt. Vielmehr wird gemäß dem Schritt 212 an anderer Stelle, nämlich auf der Rückförderseite des Saugtellers 55 der Informationsträger gemäß dem Schritt 212 durch die Trägerbahn 78, die dadurch zum Makulaturbahn 47 wird, übernommen. Es wird anschließend zum Schritt 213 gesprungen.

Wurde im Schritt 208 festgestellt, daß der Informationsträger fehlerfrei ist, so wird zum Schritt 209 übergegangen. Gemäß diesem Verfahrensschritt wird die Übernahmeeinrichtung 60 dadurch aktiviert, daß der Führungskeil 61 durch das Stellorgang 64 mit seinen Andruckrollen 62 und 63 in Anlage an den Informationsträger auf dem Saugteller 55 gebracht wird. Gemäß dem Schritt 210 folgt dann die Übernahme des fehlerfreien Informationsträgers durch die Tragbahn 59, die zur fehlerfreien Materialbahn 34 wird. Die Übernahme erfolt dadurch, daß eine dauerhaft haftende Bindung zwischen Informationsträger und Trägerbahn hergestellt wird, die jedoch ablösbar ist. Anschließend wird zum Schritt 213 übergegangen.

Gemäß dem Schritt 213 wird der Saugteller nach Übernahme des auf ihm bereit gestellten Informationsträgers zurückgefördert, damit er wiederum einen neuen Informationsträger übernehmen kann. Dabei wird er wieder in seine Ausgangslage zurückgeschwenkt, wenn während des Transportes zur Übernahmeeinrichtung ein Verschwenken des Saugtellers erfolgt ist, um den Informationsträger neu auszurichten.

Die Figur 5 teilt sich in die beiden Ansichten der Figur 5 a, die eine vergrößerte Ansicht des Umsetzers 56 der Figur 3 zeigt und eine Figur 5 b, die eine Aufsicht auf den Umsetzer 56 zeigt, bei dem allerdings weder die Ablöseeinrichtung 50 noch die Übernahmeeinrichtung 60 dargestellt ist.

Wie aus der Figur 5 a ersichtlich, besteht die Ablösevorrichtung 50 aus dem Ablösekeil 53, der in Anlage mit dem Saugteller 55 des Umsetzers 56 gebracht werden kann, indem er um seine Schwenkachse 54 durch das Stellorgan 52 verschwenkt werden kann. Während sich der Ablösekeil in Anlage an dem Saugteller 55 befindet, findet ein kontinuierlicher Vorschub des Saugtellers 55 statt. Dieser kann allein dadurch sichergestellt sein, daß der Informationsträger und die Trägerbahn der ersten Materialbahn 13 in Anlage an dem Saugteller 55 relativ zum Ablösekeil 53 bewegt wird. Der Saugteller 55 kann dann im Umsetzer 56 zur Übernahmeeinrichtung 60 gebracht werden. Die Übernahmeeinrichtung 60 besteht aus den beiden Führungsrollen 69 und 69a, sowie dem Führungskeil 61 mit seinen beiden Andruckrollen 62 und 63. Der Führungskeil 61 kann, betätigt durch das Stellorgan 64, um die Anlenkachse 65 verschwenkt werden. Dadurch kann der Führungskeil 61 dann gezielt in Anlage an einen Saugteller 55 gebracht werden, wenn ein Saugteller mit einem fehlerfreien Informationsträger auf die Übernahmeeinrichtung 60 zugefördert wird.

Die Figur 5b zeigt die Ansicht des Umsetzers 56 von oben sowie den Verlauf der Materialbahnen. Die erste Materialbahn 13, die auch fehlerhafte Informationsträger aufweisen kann, wird zugeführt. Sie gelangt in den Bereich des Saugtellers 55 und wird dort über den Ablösekeil 53 nach oben weg geführt. Der auf der ersten Materialbahn 13, mit seiner längeren Seite in Richtung der Transportrichtung der Materialbahn ausgerichtet, wird vom Saugteller 55 übernommen. Der Saugteller 55 wird nun weiter befördert. Im Bereich der Führungsschiene 82, über die der Saugteller 55 auch gefördert wird, ist eine Schwenkeinrichtung 80 ausgebildet, die den Saugteller 55 in definierter Schwenkrichtung um 90° verdreht, so daß die Informationsträger nun mit ihrer längeren Seitenkante quer zur Transportrichtung einer sie fördernden Bahn ausgerichtet sind. Es kann sich bei der Schwenkeinrichtung sowohl um eine Zwangsführung des Saugtellers als auch um eine aktive, angetriebene Schwenkeinrichtung handeln. Der Saugteller 55 wird nach dem Verschwenken weitergefördert, so daß er in den Bereich der Übernahmeeinrichtung 60 gelangt. Im Bereich der Übernahmeeinrichtung 60 wird vom Saugteller 55 der Informationsträger abgenommen und auf die Materialbahn 34 übertragen, wenn es sich um einen fehlerfreien Informationsträger handelt. Die Überprüfung, ob es sich um einen fehlerfreien Informationsträger handelt, kann auch über eine Erkennungseinrichtung 18 durchgeführt werden, die auf dem Saugteller 55 angeordnet ist. Die Informationsträger sind auf dem Saugteller 55 vereinzelt, so daß jeweils nur ein Informationsträger auf einem Saugteller 55 angeordnet ist. Nach dem Bereich, in dem die Führung der Saugteller 55 über die Führungsschienen 82 erfolgte und der sich in Längsrichtung zwischen den Bereichen der Ablöseeinrichtung 50 und der Übernahmeeinrichtung 60 erstreckt, ist ein Drehteller 81 angeordnet, der den Saugteller 55 eine 180°-Kurve beschreiben läßt. Dabei behält der Saugteller 55 eine Ausrichtung bei, in der sich die Längsseite des Inforamtionsträgers quer zur Förderrichtung einer Tragbahn befindet. Die vom Drehteller beschriebene Kurve ist so groß, daß beabstandet zu der ersten Materialbahn 13 und der fehlerfreien Materialbahn 34 aber parallel zu diesen beiden Bahnen eine leere Tragbahn 78 zugeführt werden kann. In einem Übernahmebereich, der sich an das andere Ende des Drehtellers anschließt, wird von der leeren Tragbahn 78 ein eventuell sich auf dem Saugteller 55 befindender fehlerhafter Informationsträger übernommen. Dadurch wird die leere Tragbahn 78 zur Makulaturbahn 47. Die Saugteller 55 werden nun in einer weiteren Schwenkeinrichtung wieder in ihre Ausgangsrichtung zurückgedreht, in der sie Informationsträger von der ersten Materialbahn 13 übernehmen können. Über einen weiteren Drehteller 81 werden die Saugteller 55 wieder in den Bereich der Ablöseeinrichtung 50 gebracht. Die Saugteller 55 werden als solche bezeichnet, da sie durch eine geeignete Ansaugeinrichtung, die im Saugteller selbst oder aber in den Führungsmitteln der Saugteller 55 angeordnet ist, die Informationsträger mit definierter Kraft ansaugen können. Dies erleichtert insbesondere die Übernahme des Informationsträgers von der ersten Materialbahn im Bereich der Ablöseeinrichtung 50. Die Ansaugung kann vorzugsweise über die gesamte Förderdauer des Informationsträgers auf den Saugteller 55 aufrechterhalten werden. Zum Enfernen des Informationsträgers von dem Saugteller 55 kann auch ein Blasluftstrom erzeugt werden.

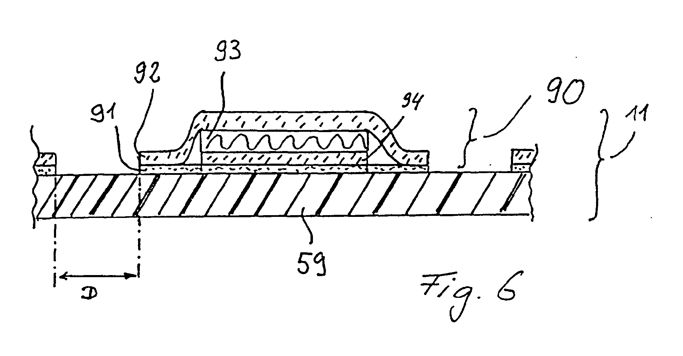

Die Figur 6 zeigt in nicht maßstäblicher, schematischer Darstellung ein Beispiel für eine Materialbahn. Es handelt sich dabei um die Materialbahn 11, die aus der Trägerbahn 59 und den darauf angeordneten Informationsträgern 90 besteht. Die Informationsträger 90 sind dabei in regelmäßigem Abstand D auf der Materialbahn 11 angeordnet, wobei sich die Trägerbahn 59 in ununterbrochener Fortführung ihres Materials, beispielsweise einem silikonbeschichteten Papiermaterial oder ähnlichem, über die gesamte Länge der Materialbahn ununterbrochen erstreckt.

Der Informationsträger 90 besteht in diesem Fall aus einem Etikett, das aus einer Deckschicht 92, beispielsweise aus einer Folie oder einem Papier oder einem Verbund aus Folie und Papier einem unter der Deckschicht angeordneten Transponder 93 mit seiner an der Unterseite befindlichen Isolierschicht 94 gebildet ist. Dabei bilden Deckschicht 92, Transponder 93 und Isolierschicht 94 eine untrennbar miteinander verbundene Einheit, die mittels der Klebeschicht, die an dem Informationsträger anhaftet, mit der Trägerbahn 59 lösbar verbunden ist. Dabei ist die Trägerbahn 59 so ausgebildet, daß die Klebeschicht 91 zwar dauerhaft aber dennoch so ablösbar an der Trägerbahn 59 anliegt, daß sie von dieser wieder beschädigungsfrei lösbar ist.

Bei den Informationsträgern, die nicht zwangsläufig einen Transponder aufweisen müssen, handelt es sich beispielsweise um alle Arten von Schicht- bzw. Bestandteilen oder Zwischenschichten von anderen Kennzeichnungseinrichtungen und Berechtigungsstücken, wie Flugtickets, Kofferanhänger, Sicherheitspapiere, Packetlabel, Chipkarten oder dergleichen oder um derartige Gegenstände. Es ist lediglich erforderlich, daß der Informationsträger auf eine entsprechende Trägerbahn aufbringbar ist und dazu geeignet ist, Informationen aufzunehmen, die automatisch ablesbar sind und verarbeitbar und auf Richtigkeit prüfbar sind. Bei den Informationen kann es sich beispielsweise auch um Barcodes-Beschriftungen, Sicherungszeichen wie Hologramme, Durchlichtmusterungen oder ähnlichen Dingen handeln.

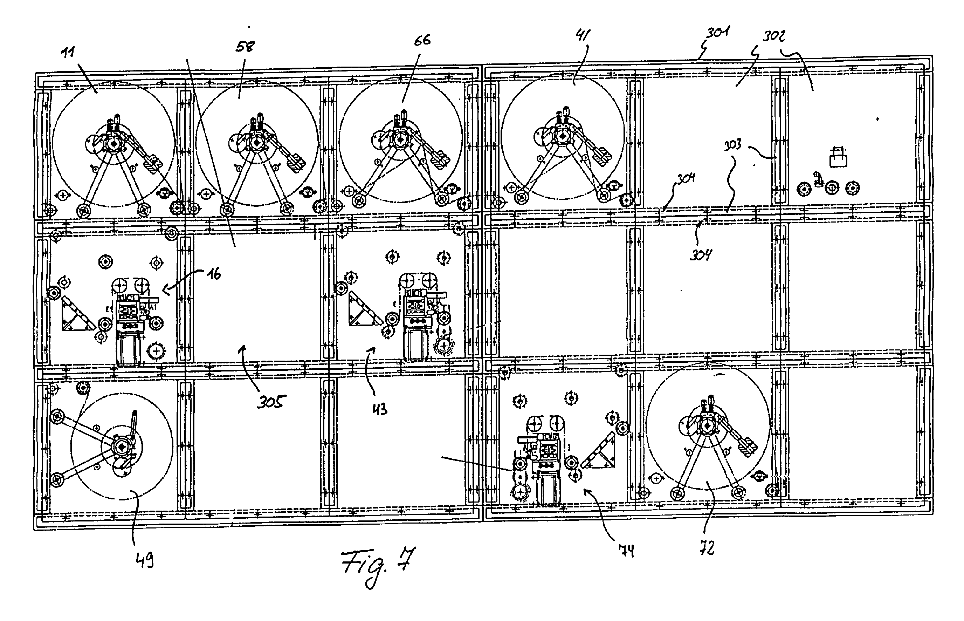

Die Figur 7 zeigt eine vorzugsweise Gestaltungsmöglichkeit für die erfindungsgemäße Vorrichtung.

Die erfindungsgemäße Vorrichtung wird aus einem gemeinsamen Rahmen 301 gebildet. Der äußere Rahmen 301 weist eine Unterteilung in Felder 302 auf, die jeweils durch quer- und hochkantverlauf enden Seitenteilen 303 begrenzt sind, wobei die Seitenteile 303 in regelmäßigen Abständen Bohrungen für die Befestigung von Einsätzen aufweist. Durch diese Vorgehensweise wird ein gleichmäßiges Raster an Feldern geschaffen, die jeweils ein gleiches, festes Maß aufweisen und einzeln oder zu mehreren zusammen eine vorgefertigte Baugruppe aufnehmen können. Dabei werden auf der Rückseite des Rahmens alle Versorgungsleitungen und Steuerleitungen, insbesondere auch Datenbusleitungen geführt und für jedes dieser Felder 302 besteht eine Anschlußmöglichkeit an einen gemeinsamen Datenbus bzw. eine Generalstromversorgung für die einzelnen Bauteile.

Desweiteren kann rückseitig auch ein bestimmtes Feld mit einer Antriebseinheit - mit einem Antriebsmotor - ausgerüstet werden. Das Rahmenteil kann entweder auf einem Unterbau, der nicht dargestellt ist, befestigt werden und der sicherstellt, daß der Rahmen nicht nach vorne und nach hinten kippt oder aber er kann fest mit dem Gebäude verbunden werden, in dem die Maschine steht.

In jedes der Kassettenfelder 302 kann eine als Modul ausgebildete Einheit eingebaut werden. In dem dargestellten Rahmen ist ein Teil der erforderlichen Baueinheiten angeordnet, wie sie für die Durchführung des Verfahrens gemäß der Vorrichtung nach Figur 3 und dem Verfahren nach Figur 4 erforderlich sind. In dem Rahmen sind angeordnet die Bahnausrichter 16, 43 und 74, wobei diese Elemente von einer Grundfläche nach vorne abragen und die Grundfläche an den Bohrungen 304 der Seitenkanten 303 befestigt sind. Jeweils ein Kassettenfach in Anspruch nehmen die Wickelvorrichtungen für die Materialbahnen mitsamt den Trommeln und jeweils mindestens einer zugeordneten Umlenkrolle, die über einen Schwenkarm beweglich in ihrer Lage bezüglich der Wickeltrommel und dem feststehend zu dem Rahmen angeordneten Umlenkrollen ist, so daß jeweils eine Pufferung der Materialbahnlänge bzw. der Trägerbahnlänge vorgenommen werden kann. Im einzelnen angeordnet sind die Rollen für die erste Materialbahn 11, die Trommel 58 für die Aufnahme der zu recycelnden Trägerbahn der ersten Materialbahn, die Trommel 66 für die Bereitstellung der Trägerbahn für die fehlerfreie Materialbahn 34, die Wickelstation 41 für die Aufnahme der fehlerfreien Materialbahn 34, die Bereitstellungsrolle 72 für die Bereitstellung der leeren Materialbahn zur Aufnahme der Makulatur und die Wickeltrommel 49 zur Aufnahme der Makulaturbahn. In der Zeichnung nicht dargestellt ist der Umsetzer 56, der gemäß dem Verfahrensablauf in dem freien Feld 305 anzuordnen wäre. In den weiteren freien Feldern können bedarfsweise entsprechend dem Anforderungsprofil des Anwenders weitere Bearbeitungsstationen aufgenommen und in den Ablauf integriert werden.

Es ist auch möglich, daß sich eine Bearbeitungsstation nicht nur über eines der Fächer erstreckt, sondern über mehrere insbesondere über zwei einander unmittelbar benachbarte Fächer. Dies ist beispielsweise der Fall bei der Wechseleinrichtung 32 der Figur 1, die sich über zwei horizontal benachbarte Kassettenfächer erstreckt und unter anderem die beiden Ablösevorrichtungen 19 und 30 sowie die beiden Saugwalzen 22 und 25 beinhaltet und die räumlich gesehen nicht in einem einzelnen Kassettenfach unterzubringen wäre.

## Patentansprüche

1. Verfahren zur Erzeugung einer Materialbahn mit auf ihr ablösbar aufgebrachten, ausschließlich fehlerfreien Informationsträgern, **dadurch gekennzeichnet, daß** zwei Materialbahnen (13, 14), die auch fehlerhafte Informationsträger enthalten, zugeführt werden, wobei von der ersten Materialbahn (13) alle fehlerhaften Informationsträger abgelöst werden und von der zweiten Materialbahn (14) nur fehlerfreie Informationsträger abgelöst werden, wobei in die durch das Ablösen eines fehlerhaften Informationsträgers entstandene Lücke in der ersten Materialbahn (13) jeweils ein fehlerfreier Informationsträger, der von der zweiten Materialbahn abgelöst wurde, eingesetzt wird.

2. Verfahren nach Anspruch 1, **dadurch gekennzeichnet, daß** in die durch das Ablösen eines fehlerfreien Informationsträgers von der zweiten Materialbahn (14) entstandene Lücke ein von der ersten Materialbahn (13) abgelöster fehlerhafter Informationsträger eingesetzt wird.

3. Verfahren nach Anspruch 1 oder 2, **dadurch gekennzeichnet, daß** das Einsetzen des fehlerfreien Informationsträgers in die durch das Ablösen eines fehlerhaften Informationsträgers entstandenen Lücke positionsgenau erfolgt und/oder das Einsetzen des fehlerhaften Informationsträgers in die durch das Ablösen eines fehlerfreien Informationsträgers entstandene Lücke positionsgenau erfolgt.

4. Verfahren nach einem der Ansprüche 1 bis 3, **dadurch gekennzeichnet, daß** eine ausschließlich fehlerhafte Informationsträger aufweisende Makulaturbahn (47) erzeugt wird.

5. Verfahren nach einem der Ansprüche 1 bis 4, **dadurch gekennzeichnet, daß** alle fehlerfreien Informationsträger in der Reihenfolge ihres Auftretens auf der zweiten Materialbahn (14) abgelöst werden.

6. Vorrichtung zum Erzeugen einer Materialbahn zur Durchführung eines Verfahrens nach einem der vorstehenden Ansprüche, **dadurch gekennzeichnet, daß** zwei auch fehlerhafte Informationsträger aufweisende Materialbahnen (13, 14) zugeführt werden, daß jeder der beiden Materialbahnen eine Erkennungseinrichtung (18, 33) zum Erkennen fehlerhafter Informationsträger und eine Ablösevorrichtung (19, 30) zugeordnet ist, wobei von der ersten der beiden Materialbahnen (13) lediglich fehlerhafte Informationsträger und von der zweiten der beiden Materialbahnen (14) lediglich nicht fehlerhafte Informationsträger abgelöst werden und daß ein Transportelement (22) zum Transportieren der von der zweiten Materialbahn (13) abgelösten fehlerfreien Informationsträger zur ersten Materialbahn, Mittel zum Einsetzen der fehlerfreien Informationsträger in Lücken der ersten Bahn und eine Transportsteuereinrichtung zum Steuern des Bahntransportes der Materialbahnen (13, 14) vorhanden ist.

7. Vorrichtung nach Anspruch 6, **dadurch gekennzeichnet, daß** der Weg vom Ablösepunkt von der ersten Materialbahn (13) bis zum Anlagepunkt des zweiten Transportelements (25) an der Materialbahn (13) größer ist als die längste verarbeitbare Ausdehnung eines Informationsträgers.

8. Vorrichtung nach Anspruch 7, **dadurch gekennzeichnet, daß** die Erkennungseinrichtung (18) im Bereich des Transportelementes (55) angeordnet ist oder in das Transportelement integriert ist.

9. Vorrichtung nach einem der Ansprüche 6 bis 8, **dadurch gekennzeichnet, daß** der Informationsträger während des Transportes bezüglich seiner Lage zur Trägerbahn (59) ausgerichtet wird.

10. Vorrichtung nach einem der Ansprüche 6 bis 9, **dadurch gekennzeichnet, daß** ein Rahmen (301) vorgesehen ist, der Felder (302) aufweist, an denen in erforderlicher Anordnung vorgefertigte Baugruppen befestigbar sind.

## Claims

1. Method for producing a material web having exclusively fault-free information carriers applied detachably to it, **characterized in that** two material webs (13, 14) which also contain faulty information carriers are delivered, all the faulty information carriers being detached from the first material web (13) and only fault-free information carriers being detached from the second material web (14), in each case a fault-free information carrier, which has been detached from the second material web, being inserted into the gap in the first material web (13) which has occurred due to the detachment of a faulty information carrier.

2. Method according to Claim 1, **characterized in that** a faulty information carrier detached from the first material web (13) is inserted into the gap which has occurred due to the detachment of a fault-free information carrier from the second material web (14).

3. Method according to Claim 1 or 2, **characterized in that** the insertion of the fault-free information carrier into the gap which has occurred due to the detachment of a faulty information carrier takes place exactly in position and/or the insertion of the faulty information carrier into the gap which has occurred due to the detachment of a fault-free information carrier takes place exactly in position.

4. Method according to one of Claims 1 to 3, **characterized in that** a spoiled web (47) having exclusively faulty information carriers is produced.

5. Method according to one of Claims 1 to 4, **characterized in that** all the fault-free information carriers are detached in the order in which they occur on the second material web (14).

6. Apparatus for producing a material web for carrying out a method according to one of the preceding claims, **characterized in that** two material webs (13, 14) also having faulty information carriers are delivered, **in that** each of the two material webs is assigned a detection device (18, 33) for detecting faulty information carriers and a detachment device (19, 30), only faulty information carriers being detached from the first of the two material webs (13) and only non-faulty information carriers being detached from the second of the two material webs (14), and **in that** a transport element (22) for transporting the fault-free information carriers detached from the second material web (13) to the first material web, means for inserting the fault-free information carriers into gaps of the first web and a transport control device for controlling the web transport of the material webs (13, 14) are present.

7. Apparatus according to Claim 6, **characterized in that** the distance from the point of detachment from the first material web (13) to the bearing point of the second transport element (25) against the material web (13) is greater than the longest processable extent of an information carrier.

8. Apparatus according to Claim 7, **characterized in that** the detection device (18) is arranged in the region of the transport element (55) or is integrated into the transport element.

9. Apparatus according to one of Claims 6 to 8, **characterized in that** the information carrier is oriented with regard to its position with respect to the carrier web (59) during transport.

10. Apparatus according to one of Claims 6 to 9, **characterized in that** a frame (301) is provided, having panels (302) to which prefabricated subassemblies can be fastened in the required arrangement.

## Revendications

1. Procédé permettant d'obtenir une bande de matière avec des supports d'informations exclusivement sans défaut déposés de manière amovible sur celle-ci, **caractérisé en ce que** l'on amène deux bandes de matière (13, 14), qui comportent également des supports d'informations défectueux, dans lequel on enlève de la première bande de matière (13) tous les supports d'informations défectueux et on n'enlève de la deuxième bande de matière (14) que des supports d'informations sans défaut, dans lequel on insère ensuite dans le vide apparu dans la première bande de matière (13) par l'enlèvement d'un support d'informations défectueux chaque fois un support d'informations sans défaut qui a été enlevé de la deuxième bande de matière.

2. Procédé selon la revendication 1, **caractérisé en ce que** l'on insère dans le vide apparu par l'enlèvement d'un support d'informations sans défaut de la deuxième bande de matière (14) un support d'informations défectueux enlevé de la première bande de matière (13).

3. Procédé selon la revendication 1 ou 2, **caractérisé en ce que** l'on effectue en position exacte l'insertion du support d'informations sans défaut dans le vide apparu par l'enlèvement d'un support d'informations défectueux et/ou on effectue en position exacte l'insertion du support d'informations défectueux dans le vide apparu par l'enlèvement d'un support d'informations sans défaut.

4. Procédé selon l'une quelconque des revendications 1 à 3, **caractérisé en ce que** l'on obtient une bande de rebut (47) présentant exclusivement des supports d'informations défectueux.

5. Procédé selon l'une quelconque des revendications 1 à 4, **caractérisé en ce que** l'on enlève tous les supports d'informations sans défaut dans l'ordre de leur apparition sur la deuxième bande de matière (14).

6. Dispositif permettant d'obtenir une bande de matière pour la mise en oeuvre d'un procédé selon l'une quelconque des revendications précédentes, **caractérisé en ce que** deux bandes de matière (13, 14) comportant également des supports d'informations défectueux sont amenées, **en ce qu'**un système de reconnaissance (18, 33) pour reconnaître des supports d'informations défectueux et un système d'enlèvement (19, 30) sont associés à chacune des deux bandes de matière, dans lequel seuls des supports d'informations défectueux sont enlevés de la première des deux bandes de matière (13) et seuls des supports d'informations non défectueux sont enlevés de la deuxième des deux bandes de matière (14), et **en ce qu'**il se trouve un élément de transport (22) pour transporter les supports d'informations sans défaut enlevés de la deuxième bande de matière (14) vers la première bande de matière, des moyens pour insérer les supports d'informations sans défaut dans des vides de la première bande et un système de commande de transport pour commander le transport en bande des bandes de matière (13, 14).

7. Dispositif selon la revendication 6, **caractérisé en ce que** le chemin depuis le point d'enlèvement de la première bande de matière (13) jusqu'au point de dépôt du deuxième élément de transport (25) sur la bande de matière (13) est plus grand que la plus longue dimension traitable d'un support d'informations.

8. Dispositif selon la revendication 7, **caractérisé en ce que** le système de reconnaissance (18) est disposé dans la région de l'élément de transport (55) ou est intégré dans l'élément de transport.

9. Dispositif selon l'une quelconque des revendications 6 à 8, **caractérisé en ce que** le support d'informations est orienté pendant le transport par rapport à sa position sur la bande de support (59).

10. Dispositif selon l'une quelconque des revendications 6 à 9, **caractérisé en ce qu'**il est prévu un cadre (301), qui présente des champs (302) sur lesquels des modules préfabriqués peuvent être fixés selon l'agencement nécessaire.
